Europäisches Patentamt

**European Patent Office**

**Office européen des brevets**

(11) Numéro de publication: **0 325 068 B1**

(12) **FASCICULE DE BREVET EUROPEEN**

(45) Date de publication de fascicule du brevet: **23.09.92**  (51) Int. Cl.5: **H01L 25/10**, H01L 23/52

(21) Numéro de dépôt: **88403248.3**

(22) Date de dépôt: **20.12.88**

(54) **Structure microélectronique hybride modulaire à haute densité d'intégration.**

(30) Priorité: **22.12.87 FR 8717879**

(43) Date de publication de la demande:
**26.07.89 Bulletin  89/30**

(45) Mention de la délivrance du brevet:
**23.09.92 Bulletin  92/39**

(84) Etats contractants désignés:
**BE DE GB**

(56) Documents cités:
**EP-A- 0 083 405       EP-A- 0 176 245
EP-A- 0 211 619       EP-A- 0 228 212
WO-A-81/02367        US-A- 4 208 698**

**ELECTRONIC PACKAGING & PRODUCTION,
vol. 26,no. 9, septembre 1986, pages 28-29,
Londres, GB; J. ANGELONI: "VLSIhybrids are
built with modular parts"**

**IBM TECHNICAL DISCLOSURE BULLETIN, vol.
19, no. 12, mai 1977, page 4541, Armonk, NY,
US; V.D. VANVESTROUT: "Hybrid module including thin-film conductors and paste resistors"**

(73) Titulaire: **THOMSON-CSF
51, Esplanade du Général de Gaulle
F-92800 Puteaux(FR)**

(72) Inventeur: **Charruau, Stéphane
THOMSON-CSF SCPI 19, avenue de Messine
F-75008 Paris(FR)**

(74) Mandataire: **Sciaux, Edmond et al
THOMSON-CSF SCPI
F-92045 PARIS LA DEFENSE CEDEX 67(FR)**

## Description

La présente invention concerne une structure microélectronique hybride modulaire selon le préambule de la revendication 1 autorisant notamment une haute densité d'intégration.

La course à la miniaturisation des fonctions électroniques a commencé à l'aube des années 1960 avec l'apparition des premiers circuits intégrés. Les progrès ont été considérables dans le domaine de la conception et de la fabrication des circuits intégrés monolithiques, ils ont été moins spectaculaires dans le domaine de la connectique de liaison entre les circuits intégrés.

Pour fixer les idées à l'aide d'un exemple concret, on considère un module qui était fabriqué vers 1980 à l'aide de 80 circuits intégrés encapsulés et montés sur un circuit imprimé à trous métallisés. Ce module occupait une surface totale de l'ordre de 270cm2. Cinq années plus tard, ce même module a pu être obtenu avec un seul circuit intégré complexe (technique d'intégration monolithique du silicium) encapsulé occupant une surface totale de 11,2cm2. La surface occupée par ce module a été ainsi réduite dans le rapport 1/23. Ce rapport de réduction de superficie se décompose en 1/15,3 pour la réduction imputable uniquement au silicium et à 1/1,5 pour la réduction de surface imputable à l'encapsulation du silicium et à la connectique de liaison entre les circuits intégrés.

Il y a donc eu, malgré d'indéniables innovations dans le domaine des encapsulations et de la connectique, des progrès de l'ordre de dix fois moins importants dans ce domaine que dans celui du silicium.

Si l'on se rapporte maintenant pour le module précité à l'hybridation sur de grandes surfaces, c'est-à-dire au report direct des 80 pastilles de semiconducteurs, correspondant aux 80 circuits intégrés précités, équipées de leur câblage filaire sur un substrat d'interconnexion, il faudra une surface de 32cm$^2$ pour réaliser le module. Dans ces conditions l'efficacité de l'hybridation comparée à celle de l'intégration monolithique du silicium montre qu'elle est trois fois meilleure en taux d'occupation du silicium sur le substrat d'interconnexion mais trois fois moins bonne en réduction de surface du substrat d'interconnexion.

En conséquence, une étape importante et inéluctable concerne l'hybridation de circuits intégrés complexes avec une perspective d'un gain de surface élevé par rapport au circuit imprimé. Sans oublier des difficultés complémentaires de test électrique, cette perspective exige une révision des technologies d'hybridation en particulier dans le domaine des substrats.

Le but de l'invention selon la revendication 1 est de concevoir une structure microélectronique hybride qui réponde à ces problèmes en utilisant au mieux les différentes technologies de réalisation des circuits multicouches, le choix des substrats et de la largeur des conducteurs, celle-ci pouvant varier dans une gamme étendue allant depuis 250 microns en technologie couches épaisses jusqu'à 25 microns en technologie couches minces.

Les modes particulieres de réalisation de l'invention sont indiqués dans les revendications dépendantes.

Les facteurs prépondérants de l'intégration hybride des modules électroniques font apparaître dans l'ordre décroissant d'influence les "paramètres" suivants :

- en premier lieu la "densité d'intégration" qui est une relation entre le nombre moyen de connexions réalisé par unité de surface de substrat destiné à l'interconnexion des composants électroniques. La densité d'intégration varie dans un rapport 100/1 pour les hybrides. Elle dépend fortement du choix des pastilles de silicium des circuits actifs.
- les règles de conception caractérisées par le "pas" qui est la distance minimale autorisée par la technologie du substrat utilisé séparant les lignes médianes de deux conducteurs coplanaires. Cette distance est égale à la somme de la largeur minimale autorisée des conducteurs et de la largeur minimale exigée d'isolement entre deux conducteurs adjacents. Le pas varie dans un rapport 10 pour les hybrides. Il dépend fortement de la technologie du substrat d'interconnexion.
- le "degré moyen topologique" ou facteur prenant en compte l'architecture des interconnexions selon le schéma électrique du module hybride. Le degré moyen topologique varie entre 1 et 2 ; c'est le nombre moyen de conducteurs s'épanouissant à partir de chaque noeud d'interconnexion.

Après caractérisation de la connectique du "substrat" par ces paramètres, on en déduit les éléments de conception du substrat : le "nombre de couches", le "nombre de vias" ou liaisons perpendiculaires au plan des couches pour relier ces couches entre elles électriquement, et la "technologie de construction" du substrat.

Les circuits hybrides sont conçus sur un substrat isolant qui, par impression (sérigraphie) ou par gravure (photolithographie), reçoit des conducteurs et des composants passifs. Les éléments actifs, constitués par des circuits intégrés simples ou complexes, sont posés sur le substrat puis soudés ou collés : on dit qu'ils sont rapportés. On distingue trois classes de circuits hybrides :

- les hybrides à couches minces (ou films minces) dont les couches superposées qui sont alternativement conductrices et isolantes sont réalisés par photolithographie. Chaque couche a une épaisseur maximale de 10 microns (abréviation usuelle pour micromètre), la largeur des conducteurs est comprise entre 10 et 30 microns, le pas est compris entre 30 et 100 microns. La limitation de ces hybrides est due au faible nombre de couches isolantes réalisables (ne dépassant pas généralement 5 couches) en superposition, par suite de difficultés technologiques et du coût résultant.

- les hybrides à couches épaisses (ou films épais) dont les couches conductrices et isolantes, alternées et superposées, sont obtenues par sérigraphies et cuissons successives. Chaque couche a une épaisseur supérieure à 10 microns, la largeur du conducteur est de 250 microns généralement et le pas de 500 microns. La limitation de ces hybrides est due au nombre maximum (ne dépassant guère 6) de couches conductrices isolées et superposées et aux difficultés de câblage filaire des pastilles de semiconducteurs en liaison avec une mauvaise planéité des sérigraphies. Réalisés en céramique, il est pratiquement impossible de produire des interconnexions entre couches par des vias.

- les hybrides à couches épaisses dont les couches conductrices sont obtenues par sérigraphie sur des couches isolantes, lesquelles sont des feuilles de céramique placées les unes sur les autres, pressées puis cuites ensuite ensemble en une seule fois après perçage des vias d'interconnexions entre couches et sérigraphie des conducteurs. Ces céramiques sont dites "cocuites". Le nombre de couches isolantes n'étant plus une contrainte, la limitation de ces hybrides provient des contraintes de câblage filaire des pastilles de semiconducteurs à grand nombre de plots d'entrée-sortie dont l'intervalle est très inférieur au pas minimum des sérigraphies (300 microns). Sur l'une ou les deux faces du substrat multicouches à couches épaisses du type cocuit sont disposés les éléments actifs utilisés, tels des circuits intégrés monolithiques encapsulés et ceux sous forme de pastille de semiconducteur encapsulés collectivement (hybrides classiques).

Il est nécessaire par ailleurs de réaliser en technologie hybride à couches minces multiples des circuits à très haute densité d'intégration comportant, en particulier, au moins une pastille de semiconducteur rapportée sur le substrat multicouches à couches minces ayant un grand nombre (qui peut être supérieur à 100) d'entrées-sorties dont l'intervalle a une dimension très inférieure au pas minimum (de l'ordre de 300 microns) autorisé par l'état de l'art des sérigraphies en technologie des couches épaisses. Les contraintes essentielles imposées par ces circuits couches minces multiples sont les suivantes :

- la nécessité d'un substrat servant de support mécanique aux couches minces, une céramique telle que l'alumine est souvent utilisée ;
- la réalisation d'un nombre de couches supérieur à trois s'avère délicate et d'un coût prohibitif ;
- le raccordement est à effectuer par des connexions filaires entre le substrat couches minces et l'extérieur ;
- le montage est à protéger de l'environnement, en particulier de l'humidité, en le plaçant sous un boîtier à travers lequel il faut assurer la connectique externe.

Un objet de l'invention est de concilier les technologies à couches minces avec les technologies à couches épaisses pour améliorer les performances d'une structure hybride en matière de densité d'intégration, notamment lorsque les circuits comportent des pastilles de semiconducteurs à très grand nombre d'entrées-sorties. On verra ultérieurement que d'autres avantages résultent de l'invention, entre autre :

- une meilleure adaptation locale aux différentes densités d'intégration des circuits rapportés ;
- une suppression de câblage filaire en périphérie du module hybride couches minces ;
- une réduction optimale du nombre des couches minces ;
- une réduction optimale du nombre des couches conductrices des couches épaisses ;
- un découplage facilité des alimentations sans perte de superficie pour les connexions ;
- l'évacuation aisée de la chaleur dans l'environnement ;
- le montage et le démontage aisés du module hybride avec des interconnesions extérieures désolidarisables mécaniquement du module etc ...

Suivant l'invention, il est réalisé une structure microélectronique hybride modulaire à haute densité d'intégration, comportant des composants microélectroniques actifs encapsulés raportés sur au moins une face d'un substrat à couches épaisses, caractérisé en ce qu'elle comporte, en outre, au moins un circuit hybride encapsulé regroupant en son sein des circuits à haute densité d'intégration formés par au moins une pastille semi-conductrice rapportée sur un substrat à couches minces, ces dernières étant développées directement sur une face dudit substrat à couches épaisses qui leur sert de support mécanique.

Suivant une autre caractéristique de l'invention, les interconnexions entre les divers composants encapsulés montés sur l'une ou les deux faces du substrat à couches épaisses sont réalisables en volume au sein même de ce substrat, de telle manière qu'il n'existe aucun conducteur externe de liaison sur les faces apparentes du module mais seulement des bornes entrées-sorties.

De plus, au sein même du substrat composite, les interconnexions du substrat à couches minces, rapporté directement sur le substrat à couches épaisses, avec le réseau électrique interne au substrat à couches épaisses sont réalisées sans câblage filaire de couches minces à couches épaisses grâce à des vias métallisés au sein des couches minces en liaison électrique avec des vias métallisés au sein des couches épaisses. Ces vias métallisés ne sont pas nécessairement distribués en périphérie de l'aire occupée par les couches minces mais peuvent être avantageusement distribués sur toute l'aire occupée par les couches minces afin d'obtenir les connexions les plus courtes.

L'invention s'applique à toute filière technologique satisfaisant au principe des interconnexions tridimensionnelles entre les composants, sous ou sur lesdits composants. Sont valables les filières tels que les circuits imprimés multicouches avec couche de fermeture, les multicouches épaisses céramiques cocuites, les multicouches minces.

Les particularités et avantages de l'invention apparaîtront dans la description qui suit donnée à titre d'exemple, à l'aide des figures annexées qui représentent :

- Fig.1, un schéma d'une structure hybride conforme à l'invention,
- Fig.2, un schéma relatif au montage ou au démontage de la structure selon figure 1,
- Fig.3, une vue en perspective de la structure modulaire hybride selon l'invention, après montage,
- Fig.4, une vue latérale de la structure modulaire hybride selon l'invention, après montage montrant notamment la possibilité d'adjonction aisée d'un radiateur pour la dissipation thermique,
- Fig.5, un schéma relatif au découplage des alimentations réalisable dans le substrat couches épaisses de la structure modulaire conforme à l'invention.
- Fig.6 et fig.7, des schémas de détail relatifs aux interconnexions dans le substrat composite constitué par le substrat couches épaisses et le substrat couches minces.

L'exemple de réalisation d'une structure hybride modulaire conforme à l'invention représenté sur les figures correspond à un mode préférentiel mais non limitatif d'exécution, ainsi qu'on le verra par la suite.

Suivant cette réalisation préférentielle, le module se compose d'un substrat multicouches 1 supportant sur une face, des pastilles de semi-conducteur 2 à haute densité d'intégration ; sur l'autre face sont disposés des circuits intégrés de moindre densité disponibles sous forme de composants électroniques 3 encapsulés et rapportés sur cette face.

Les pastilles 2 sont encapsulées collectivement sous un boîtier 4 qui peut être constitué d'un cadre 5 et d'un capot 6.

Les pastilles de semi-conducteur 2 sont interconnectées à l'aide d'un substrat 8 réalisé en technologie couches minces préférentiellement utilisable pour de tels circuits à haute densité d'intégration. Le nombre des couches minces est préférentiellement limité à une, deux, trois ou quatre au plus, compte tenu du coût élevé et de la difficulté d'exécution au-delà de quatre couches. Ces couches minces sont développées successivement sur la face correspondante du substrat 1 préférentiellement selon l'ordre suivant :

- couche mince la plus profonde qui est celle d'accrochage des vias d'interconnexion avec le réseau électrique du substrat 1 sur sa face correspondante,
- couche mince suivante située au-dessus de la couche d'accrochage avec des conducteurs parallèles à l'un des côtés du substrat 8,
- couche mince suivante comportant des conducteurs perpendiculaires aux précédents,
- et couche mince la plus élevée, celle de report des pastilles de semiconducteur 2 et éventuellement d'autres composants électroniques.

L'ensemble 2-8 placé sous le boîtier 8 constitue un circuit hybride 10 encapsulé rapporté sur une face du substrat support 1.

Le substrat 1 utilise la technologie des couches épaisses. Il est de préférence à base de feuilles de céramique cocuites composées d'alumine, de verre, de cordiérite ou mieux encore de nitrure d'aluminium ou équivalent. Le substrat constitue le support mécanique de tous les circuits rapportés, en particulier, d'au moins un ensemble encapsulé à haute densité d'intégration 2 et 8. Le substrat 1 réalise aussi physiquement le réseau électrique d'interconnexion des composants rapportés entre eux et en particulier avec le (ou les) ensemble(s) encapsulé(s) à haute densité d'intégration 2 et 8. Il constitue en outre un drain thermique de conductibilité élevée s'il est à base de nitrure d'aluminium ou équivalent. D'autres fonctions sont assurées par ce substrat 1 qui permet le découplage élevé des alimentations et le regroupement interne des interconnexions de forte intensité de courant et des interconnexions entre les deux faces et vers l'extérieur.

Les composants 3 peuvent être répartis si nécessaire sur les deux faces du substrat 1 ; de même l'ensemble hybride 2 + 8 à haute densité peut se trouver reproduit ou réparti sur les deux faces, ou en plusieurs endroits sur une face, selon la complexité et la conception la plus avantageuse qui sera choisie pour réaliser le module.

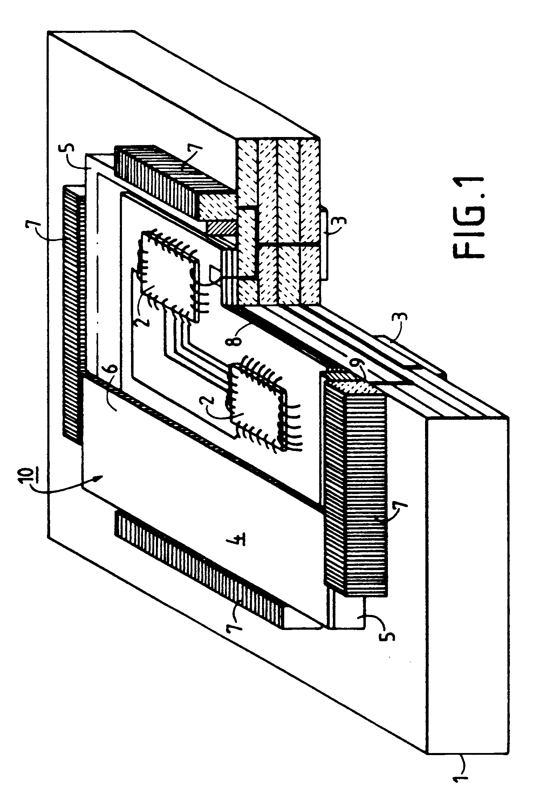

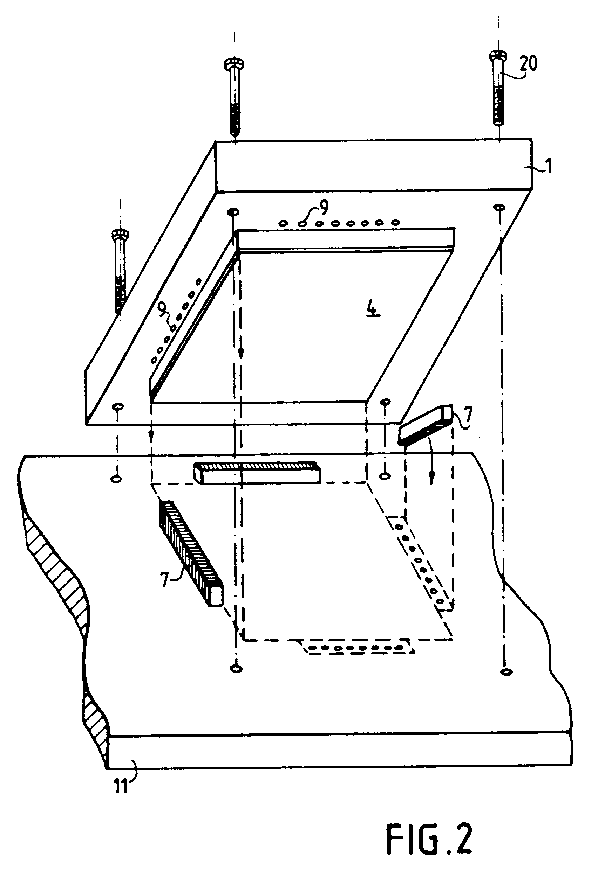

Les interconnexions vers l'extérieur sont réalisées par des plots entrées-sorties 9 sur le substrat 1. Ces entrées-sorties comme on peut le voir sur la coupe figure 1 sont reliées aux composants 2 et 3 par des connexions enterrées dans le substrat 1. Les bornes d'entrée et sortie 9 sont de préférence regroupées en périphérie du boîtier 4 (fig.2) et les connexions vers l'extérieur ne s'effectue pas par des fils mais au moyen d'une connectique élastomérique 7, la structure 4 étant, du moins extérieurement, isolante électriquement. Les conducteurs élastomériques 7 ne sont pas solidaires de la structure modulaire, ils sont introduits au cours du montage comme on peut le voir sur la figure 2.

Le module ainsi obtenu comporte aucun fil extérieur visible et il permet un montage et un démontage aisés. La fixation s'effectue par exemple au moyen de quatre vis (figures 2,3 et 4).

Les circuits denses 10 formés à partir des pastilles de semi-conducteur 2 sur substrat à couches minces 8 sont regroupés de préférence sur une face du substrat 1 et encapsulés collectivement par le boîtier 4 ; les circuits moins denses 3 ou composants additionnels peuvent être reportés sur le substrat en couches épaisses 1 sur l'autre face. Ces composants 3 sont reportés à plat, choisis de préférence encapsulés sans broches d'interconnexion extérieure avec métallisation extérieure pour être collés ou soudés. Les pastilles de semi-conducteur 2 sont connectées au réseau électrique interne du substrat à couches minces 8, ou bien par des fils soudés en leur périphérie selon la technique classique des semiconducteurs, ou bien par la technique des pastilles retournées et soudées directement sur le substrat 8, ou bien encore par la technique dite de câblage collectif couches minces des pastilles après planarisation.

La technique des couches minces permet une grande finesse des conducteurs. La largeur de ceux-ci est de l'ordre de 25 microns si bien qu'elle est particulièrement adaptée à la réalisation du réseau électrique des signaux logiques échangés entre des circuits à haut niveau d'intégration.

En revanche, cette technique est coûteuse pour le réalisation des conducteurs à forte densité de courant (alimentations, masse, etc...).

Dans la technique des couches épaisses on utilise les conducteurs larges (par exemple 250 microns) et donc favorables à la réalisation des conducteurs à forte intensité de courant ou à la liaison entre circuits à faible ou moyen niveau d'intégration. Cette dernière technique est coûteuse voire même impossible à utiliser en application d'interconnexions à très haute densité qui exigerait un nombre de couches trop élevé.

Le module permet ainsi une adaptation locale aux différentes densité d'intégration des composants. Suivant les figures 2 à 4, l'ensemble du module est connecté à plat sur un support extérieur 11, par exemple un circuit imprimé, et se trouve monté en position inversée en ce qui concerne les pastilles de semi-conducteurs 2 dans le boîtier 4, ce boîtier étant placé du côté de la carte imprimée 11.

Le couvercle ou capot 6 est soit collé, soit soudé sur le cadre 5 selon les matériaux utilisés. Avec un cadre métallique, le capot pourra être soudé, mais le cadre et le capot devront dans ce cas être isolés électriquement à l'extérieur, par exemple à l'aide d'un vernis. On peut également utiliser de la céramique pour former le cadre 5 et le capot, lequel peut être collé sur le cadre 5. Le cadre 5 peut être rendu monobloc avec le substrat 1 en le formant au cours de l'opération de pressage du multicouche.

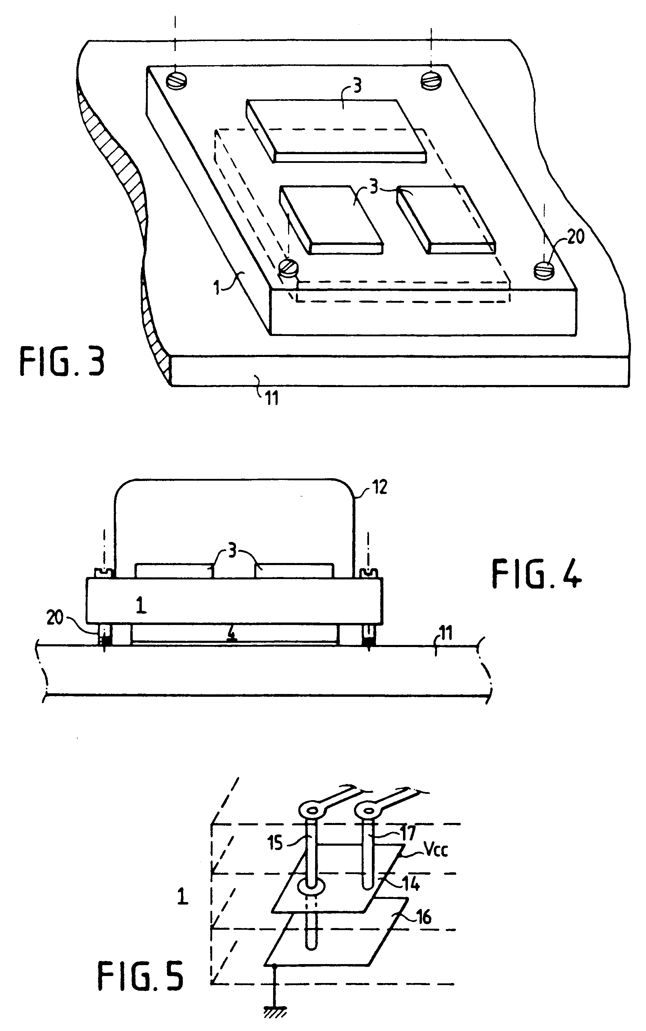

Le montage obtenu comme représenté figure 3 fait apparaître dans la position inversée la facilité d'évacuation de la chaleur par l'intermédiaire du substrat 1 qui constitue un bon drain thermique, en particulier s'il est en nitrure d'aluminium. Cet échange de chaleur est facilité avec l'environnement et n'exige pas de précautions particulières du côté circuit imprimé 11. Pour accroître encore l'échange de chaleur on peut poser aisément comme représenté figure 4, un radiateur 12 sur la face supérieure portant les composants 3.

Les éléments 7 d'interconnexions extérieures, amovibles, sont positionnés dans le substrat 1 en prévoyant par exemple l'aménagement de murs ou de gorges sur la carte imprimée 11.

Le boîtier 4 est conçu étanche pour des applications usuelles et hermétique pour des applications militaires exigeant une étanchéité plus rigoureuse.

Les critères relatifs au choix de la solution sont plus particulierement :
- la recherche d'un nombre de couches minimal pour traiter les signaux et faciliter la fabrication de l'ensemble ;
- la rapidité de réponse des signaux qui exige pour des signaux rapides des constantes diélectriques faibles et donc l'utilisation d'une technologie en couches minces organiques (par exemple polyimide) ou minérales (par exemple $SiO_2$) ;
- l'évacuation calorifique ;
- le découplage des alimentations en formant des capacités de découplage dans le substrat en couches épaisses, ces capacités n'étant pas réalisables en couches minces qu'au prix d'une complexité importante entraînant un coût élevé.

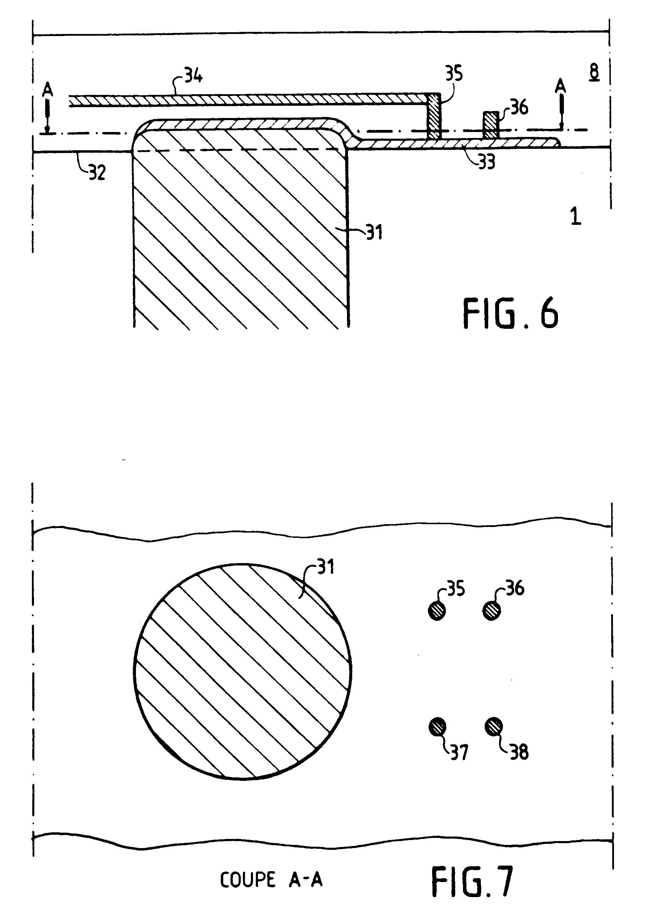

La figure 5 montre la réalisation d'une telle capacité de découplage dans le substrat 1 à l'aide de métallisations de grande surface 14 et 16 sur deux couches, l'une connectée à la masse, l'autre à une tension continue $V_{cc}$,et les traversées par des vias 15,17 pour aller jusqu'aux conducteurs correspondants.

Le substrat en couches minces 8 est réalisé par dépôt d'une couche organique ou minérale et ensuite par dépôt de conducteurs sur cette couche. On répète l'opération de dépôt d'une couche isolante revêtue d'une deuxième couche de conducteurs autant de fois qu'il y a de couches minces nécessaires à l'interconnexion des pastilles 2.

L'opération de dépôt d'une couche organique peut être réalisée par centrifugation suivie d'un cuisson et d'une polymérisation (à l'aide d'une exposition aux rayons ultraviolets par exemple).

Une couche minérale peut être déposée par voie chimique, oxydation pour le dioxyde de silicium $SiO_2$, ou à l'aide des techniques de plasma dans le cas par exemple du nitrure de silicium.

L'opération de revêtement métallique peut être réalisée par évaporation sous vide ou par pulvérisation cathodique de métaux purs sur la couche isolante organique ou minérale puis gravée par plasma.

Les vias d'interconnexion entre couches métallisées sont réalisés par gravure plasma de la couche isolante supérieure, puis métallisés lors du revêtement métallique de cette couche.

Le module ainsi constitué ne présente aucun fils apparents et aucun autre type de connexions visibles sur les faces, puisque les interconnexions entre les pastilles 2 sont réalisées à l'intérieur du boîtier 4 et les interconnexions avec et entre les composants 3 sont réalisés par l'intermédiaire des vias, à travers les couches internes du substrat 1.

Seuls apparaissent les contacts entrée/sortie 9 destinés aux liaisons extérieures par l'intermédiaire des éléments connecteurs élastomériques 7 amovisbles. Ces connecteurs 7 sont réalisés de manière connue par des boucles de conducteurs ayant la forme d'un C sur un support isolant et disposés à un pas faible vis-à-vis de celui des connections à réaliser, par exemple de l'ordre du tiers de celui des contacts successifs 9 à connecter vers l'extérieur. Ainsi, un déplacement longitudinal de faible amplitude de ces connecteurs 7 ne perturbe pas la mise en coïncidence avec les points à connecter.

Le module ainsi constitué présente une très bonne tenue à l'environnement, en particulier à l'humidité, étant donné que les divers composants 3 sont encapsulés ainsi que l'ensemble des pastilles 2 sous le boîtier 4, lequel protège également le substrat 8 en couches minces de l'environnement.

Les composants 3 sont de préférence choisis sans pattes d'interconnexion en utilisant un substrat 1 en céramique cocuite, bien adapté en dilatation thermique à de tels circuits.

La figure 6 représente un schéma de détail d'interconnexion entre le substrat à couches minces 8 et le substrat à couches épaisses (1). La figure 7 se rapporte à la coupe AA indiquée. Les interconnexions s'effectuent par l'intermédiaire des vias perpendiculaires aux couches épaisses. On a représenté un via 31 qui peut être en argent. Ce via déborde un peu au-dessus de la face supérieure 32 des couches épaisses sur laquelle a été déposée directement la première couche dite couche d'accrochage du substrat multicouches à couches minces 8. Avant d'effectuer cette opération, une couche de métal d'accrochage 33 est déposée sur la céramique et sur l'extrémité du via. A l'intérieur du substrat à couches minces 8 on a représenté une liaison horizontale 34 conductrice (déposée sur une couche isolante et se trouvant entre deux couches isolantes, pour la simplification les couches isolantes n'ont pas été figurées) qui peut être en aluminium et qui est raccordé verticalement, par l'intermédiaire d'un via 35 en aluminium, à la couche métallique d'accrochage 33. Un autre via 36 est représenté pour réaliser d'autres interconnexions. Sur la figure 7 on distingue dans le plan de coupe le via de gros diamètre 31 qui se situe dans le substrat à couches épaisses essentiellement et les vias de beaucoup plus faible diamètre 35 et 36, ainsi que deux autres 37 et 38 réalisés à l'intérieur des couches minces.

## Revendications

1. Structure microélectronique hybride modulaire à haute densité d'intégration, comportant des composants microélectroniques actifs encapsulés (3) et des pastilles de composants microélectroniques à haute densité, d'intégration (2), cette structure étant caractérisée en ce que les composants encapsulés (3) sont reportés sur un substrat multicouches à couches épaisses (1) et les pastilles de composants à haute densité d'intégration (2) sont reportées sur au moins un substrat multicouches à couches minces (8), ce dernier étant développé sur une face du substrat à couches épaisses (1) qui lui sert de support mécanique.

2. Structure selon la revendication 1, caractérisée en ce que le substrat multicouches à couches épaisses (1) est de type minéral, en couches d'alumine ou de nitrure d'aluminium, et le substrat multicouches à couches minces (8) est de type organique, en couches de polyimide.

3. Structure selon la revendication 1, caractérisée en ce que au moins un composant à haute densité d'intégration (2) reporté sur un substrat multicouches à couches minces (8) est encapsulé dans un boîtier (10) porté par une face du substrat multicouches à couches épaisses.

4. Structure selon l'une quelconque des revendications précédentes, caractérisée en ce que le substrat à couches épaisses (1) est en céramique cocuite.

5. Structure selon l'une quelconque des revendications précédentes, caractérisée en ce que les interconnexions entre les composants encapsulés (2,3) portés par les deux faces du substrat à couches épaisses (1) sont réalisés en volume au sein même de ce substrat par l'intermédiaire de vias de manière qu'il n'existe aucun conducteur apparent de liaison sur les faces du substrat.

6. Structure selon l'une quelconque des revendications précédentes, caractérisée en ce que les interconnexions entre le substrat à couches minces (8) et le substrat à couches épaisses (1) s'effectuent sans câblage filaire par l'intermédiaire des vias.

7. Structure selon la revendication 6, caractérisée en ce que les vies d'interconnexion entre couches minces et couches épaisses sont réparties sur toute l'aire de l'interface couches minces-couches épaisses.

8. Structure selon l'une quelconque des revendications précédentes, caractérisée en ce que les interconnexions entre les divers composants encapsulés portés par les deux faces du substrat à couches épaisses (1) et l'extérieur sont réalisés au sein même de ce substrat pour aboutir à des bornes d'entrée/sortie (9) aboutissant sur l'une des faces dudit substrat à couches épaisses de telle manière qu'il n'apparaît aucun conducteur externe de liaison sur les faces de ce substrat mais seulement ces bornes d'entrée/sortie.

9. Structure selon la revendication 8, caractérisée en ce que lesdites bornes d'entrée/sortie sont réparties à la périphérie de la structure hybride à l'extérieur et à proximité d'un boîtier (4) recouvrant de manière étanche ledit circuit hybride (10).

10. Structure selon la revendication 9, caractérisée en ce que les raccordements extérieurs desdites bornes d'entrée-sortie (9) s'effectuent par l'intermédiaire de connecteurs élastomériques (7) amovibles qui sont introduits au cours du montage de le structure modulaire.

11. Structure selon la revendication 8,9 ou 10, caractérisée en ce qu'elle est montée de manière à présenter le circuit hybride (10) au-dessous du substrat à couches épaisses (1) et les composants actifs encapsulés (3) au-dessus de ce substrat.

12. Structure selon la revendication 11, caractérisée en ce qu'eue comporte un radiateur (12) d'évacuation thermique placé sur la face portant lesdits composants actifs (3).

13. Structure selon l'une quelconque des revendications précédentes, caractérisée en ce que des moyens de découplage capacitif d'alimentation continue (14 à 17) sont réalisés au sein même du substrat à couches épaisses (1).

**Claims**

1. Modular hybrid microelectronic structure with high-integration density, comprising encapsulated active microelectronic components (3) and microelectronic component chips with high-integration density (2), this structure being characterised in that the encapsulated components (3) are attached to a thick-film multi-layer substrate (1) and the component chips with high-integration density (2) are attached to at least one thin-film multi-layer substrate (8), the latter being developed on one face of the thick-film substrate (1) which serves as its mechanical support.

2. Structure according to Claim 1, characterised in that the thick-film multi-layer substrate (1) is of mineral type, made in layers of alumina or of aluminium nitride, and the thin-film multi-layer substrate (8) is of organic type, made in layers of polyimide.

3. Structure according to Claim 1, characterised in that at least one component with high-integration density (2) attached to a thin-film multi-layer substrate (8) is encapsulated into a housing (10) carried by one face of the thick-film multi-layer substrate.

4. Structure according to any one of the preceding claims, characterised in that the thick-film substrate (1) is made in co-fired ceramic.

5. Structure according to any one of the preceding claims, characterised in that the interconnections between the encapsulated components (2, 3) carried by the two faces of the thick-film substrate (1) are produced in volume within this substrate by the use of vias such that there exists no apparent linking conductor on the faces of the substrate.

6. Structure according to any one of the preceding claims, characterised in that the interconnections between the thin-film substrate (8) and the thick-film substrate (1) are made without wire cabling by the use of vias.

7. Structure according to Claim 6, characterised in that the interconnection vias between thin films and thick films are distributed over all of the area of the thin films - thick films interface.

8. Structure according to any one of the preceding claims, characterised in that the interconnections between the various encapsulated components carried by the two faces of this thick-film substrate (1) and the exterior are produced within this substrate in order to end up at input/output terminals (9) ending on one of the faces of the said thick-film substrate in such a way that no external linking conductor appears on the faces of this substrate but only these input/output terminals.

9. Structure according to Claim 8, characterised in that the said input/output terminals are distributed around the periphery of the hybrid structure outside and in proximity to a housing (4) covering, in a leaktight manner, the said hybrid circuit (10).

10. Structure according to Claim 9, characterised in that the external connections of the said input/output terminals (9) are made by use of removable elastomeric connectors (7) which are inserted in the course of mounting of the modular structure.

11. Structure according to Claim 8, 9, or 10, characterised in that it is mounted in such a way as to exhibit the hybrid circuit (10) below the thick-film substrate (1) and the encapsulated active components (3) above this substrate.

12. Structure according to Claim 11, characterised in that it comprises a thermal removal radiator (12) placed on the face carrying the said active components (3).

13. Structure according to any one of the preceding claims, characterised in that direct current supply capacitive decoupling means (14 to 17) are produced within the thick-film substrate (1).

**Patentansprüche**

1. Modulare hybride Mikroelektronik-Struktur von hoher Integrationsdichte mit eingekapselten, aktiven Mikroelektronik-Bauteilen (3) und Chips von Mikroelektronik-Bauteilen hoher Integrationsdichte (2), wobei diese Struktur **dadurch gekennzeichnet** ist, daß die eingekapselten Bauteile (3) von und auf einem mehrschichtigen Substrat mit dicken Schichten (1) aufgebracht sind und die Chips der Bauteile hoher Integrationsdichte (2) auf mindestens einem mehrschichtigen Substrat mit dünnen Schichten (8) aufgebracht sind, wobei das letztere sich auf einer Seite des Dickschichtsubstrats (1) erstreckt, das ihm als mechanischer Träger dient.

2. Struktur nach Anspruch 1, dadurch gekennzeichnet, daß das mehrschichtige Substrat mit dicken Schichten (1) aus Aluminiumoxidschichten oder aus Aluminiumnitridschichten vom mineralischen Typ und das mehrschichtige Substrat mit dünnen Schichten (8) aus Polyimidschichten vom organischen Typ ist.

3. Struktur nach Anspruch 1, dadurch gekennzeichnet, daß mindestens ein Bauteil hoher Integrationsdichte (2), das auf dem mehrschichtigen Substrat mit dünnen Schichten (8) aufgebracht ist, in einem Gehäuse (10) eingekapselt ist, das von einer Seite des mehrschichtigen Substrats mit dicken Schichten getragen wird.

4. Struktur nach einem der vorhergehenden Ansprüche, dadurch gekennzeichnet, daß das Dickschichtsubstrat (1) aus gemeinsam gebrannter Keramik ist.

5. Struktur nach einem der vorhergehenden Ansprüche, dadurch gekennzeichnet, daß die Verbindungen zwischen den eingekapselten Bauteilen (2, 3), die von den beiden Seiten des Dickschichtsubstrats (1) getragen werden, im Volumen im Inneren dieses Substrats mittels Stegen so ausgebildet sind, daß kein zum Vorschein kommender Leiter der Verbindungen auf den Seiten des Substrats existiert.

6. Struktur nach einem der vorhergehenden Ansprüche, dadurch gekennzeichnet, daß die Verbindungen zwischen dem Dünnschichtsubstrat (8) und dem Dickschichtsubstrat (1) ohne Verdrahtung mit Drähten mittels Stegen ausgeführt sind.

7. Struktur nach Anspruch 6, dadurch gekennzeichnet, daß die Verbindungsstege zwischen dünnen Schichten und dicken Schichten über die gesamte Dünnschicht-Dickschicht-Übergangsfläche verteilt sind.

8. Struktur nach einem der vorhergehenden Ansprüche, dadurch gekennzeichnet, daß die Verbindungen zwischen den diversen eingekapselten Bauteilen, die von den beiden Seiten des Dickschichtsubstrats (1) getragen werden, und dem Äußeren im Inneren dieses Substrats ausgebildet sind, um an Ein-/Ausgangsklemmen (9) anzugrenzen, die an eine der Seiten des Dickschichtsubstrats derart angrenzen, daß kein äußerer Verbindungsleiter auf den Seiten dieses Substrats und nur die Ein-/Ausgangsklemmen zum Vorschein kommen.

9. Struktur nach Anspruch 8, dadurch gekennzeichnet, daß diese Ein-/Ausgangsklemmen außen an der Peripherie der hybriden Struktur und in der Nähe eines Gehäuses (4) verteilt sind, das luftdicht die hybride Schaltung bedeckt.

10. Struktur nach Anspruch 9, dadurch gekennzeichnet, daß die äußeren Verbindungsstücke dieser Ein-/Ausgangsklemmen (9) mittels abnehmbaren Elastomerleitern (7) ausgeführt sind, die während der Montage der modularen Struktur eingefügt werden.

11. Struktur nach den Ansprüchen 8, 9 oder 10, dadurch gekennzeichnet, daß sie so zusammengebaut ist, daß sie die hybride Schaltung (10) unterhalb des Dickschichtsubstrats (1) und die eingekapselten aktiven Bauteile (3) oberhalb dieses Substrats aufweist.

12. Struktur nach Anspruch 11, dadurch gekennzeichnet, daß sie einen Kühlkörper (12) zum Abführen der Wärme enthält, der auf der Seite angebracht ist, die diese aktiven Bauteile (3) trägt.

13. Struktur nach einem der vorhergehenden Ansprüche, dadurch gekennzeichnet, daß Mittel zur kapazitiven Entkopplung der Gleichstromversorgungsquelle (14 bis 17) im Inneren des Dickschichtsubstrats (1) ausgebildet sind.

FIG.1

FIG.2

FIG. 3

FIG. 4

FIG. 5

FIG. 6

COUPE A-A          FIG.7